# EUROPEAN PATENT APPLICATION

(11) **EP 1 549 109 A2**
(43) Date of publication of application: **29.06.2005**
(21) Application number: 04029229.4
(22) Date of filing: 09.12.2004
(51) Int. Cl.: H05B 33/10, H05B 33/20, H05B 33/22, H01L 33/00

(54) **Electroluminescence device**

(30) Priority: 10.12.2003 JP 2003412076
(71) Applicant: Kabushiki Kaisha Toyota Jidoshokki, Kariya-shi, Aichi-ken (JP)
(72) Inventor: Takeuchi, Norihito, Kariya-shi Aichi-ken (JP); Ishikawa, Haruyuki, Kariya-shi Aichi-ken (JP); Yoshida, Mikio, Kariya-shi Aichi-ken (JP); Koike, Shuji, Kariya-shi Aichi-ken (JP)
(74) Representative: Leson, Thomas Johannes Alois, Dipl.-Ing.

(57) **Abstract**

A bottom emission type electroluminescence device for emitting an increased amount of light rays in a direction that is within a predetermined angle relative to a light incidence surface of a transparent substrate. The transparent substrate (2) is sandwiched between an electroluminescence element (3) and a transparent layer (1). The refractive index of the transparent layer is greater than that of the transparent substrate. A plurality of projections and recesses are formed on the upper surface (1b) of the transparent layer.

## Description

This application is based upon and claims the benefit of priority from prior Japanese Patent Application No. 2003-412076, filed on December 10, 2003, the entire contents of which are incorporated herein by reference.

The present invention relates to a bottom emission type electroluminescence device.

Various types of electroluminescence devices, such as organic and non-organic electroluminescence (EL) devices, have been proposed.

One example of an electroluminescence device is a bottom emission type device. In the bottom emission type electroluminescence device, light is generated by an electroluminescence element arranged on a transparent substrate. The light passes through the transparent substrate and is emitted out of the electroluminescence device. However, the light generated by the electroluminescence element can only be partially used in the conventional bottom emission type electroluminescence device. This is for the reasons described below.

The transparent substrate used for the electroluminescence device must have the following properties:
(i) the transparent substrate must be capable of an electroluminescence element being formed and supported thereon;
(ii) the transparent substrate must prevent air and moisture from entering the electroluminescence element; and
(iii) the transparent substrate must be easily available.

Materials fulfilling these requirements that may actually be employed all have a refractive index that is greater than that of the ambient atmosphere (normally, air) of the electroluminescence device.

When a transparent substrate has such a high refractive index , among the light rays reaching the interface between the transparent substrate and the ambient atmosphere, or a light emission surface of the transparent substrate, the light rays reaching the light emission surface at an angle greater than the critical angle are completely reflected toward the electroluminescence element. The completely reflected light rays are emitted out of the electroluminescence device from the sides of the transparent substrate or are guided into the electroluminescence device and attenuated. Thus, such light rays are not emitted from the light emission surface and are not used. This lowers the light exiting efficiency of the electroluminescence device.

Japanese Laid-Open Patent Publication No. 2000-323272. proposes the roughening of the light emission surface and the arrangement of a diffusion film on the light emission surface to increase the light exiting efficiency.

However, the light rays emitted from a rough light emission surface are light rays traveling in the electroluminescence device in a direction that is greater than the critical angle at the light emission surface. Thus, much of the light rays are emitted in a direction greater than at an angle that is normal to the light emission surface.

It is normally desired to increase light rays traveling in a direction normal to a light incidence surface in the electroluminescence device. This is because a person viewing the light rays emitted from the electroluminescence device or an object illuminated by the light rays is located in front of the electroluminescence device.

Accordingly, it is desirable that the light rays emitted in a certain direction, especially at an angle normal to the light incidence surface, be increased for the electroluminescence device.

It is an object of the present invention to provide a bottom emission type electroluminescence device for increasing the light rays emitted in a direction that is in a predetermined angular range relative to the light emission surface of the transparent substrate.

One aspect of the present invention is an electroluminescence device provided with a transparent substrate having a first refractive index and including a first surface and a second surface. An electroluminescence element is arranged on the first surface of the transparent substrate. A transparent layer is laminated on the second surface of the transparent substrate. The transparent layer has a second refractive index that is greater than the first refractive index of the transparent substrate and includes a third surface contacting the second surface of the transparent substrate and a fourth surface opposite to the third surface. The fourth surface of the transparent layer has at least either one of a plurality of recesses and a plurality of projections. The electroluminescence element generates light rays that pass through the transparent substrate to be emitted from the fourth surface.

Another aspect of the present invention is a method for manufacturing an electroluminescence device. The method includes preparing a transparent substrate having a first refractive index and including a first surface and a second surface, arranging an electroluminescence element on the first surface of the transparent substrate, and laminating a transparent layer on the second surface of the transparent substrate. The transparent layer has a second refractive index that is greater than the first refractive index of the transparent substrate and includes a third surface contacting the second surface of the transparent substrate and a fourth surface opposite to the third surface. The fourth surface of the transparent layer has at least either one of a plurality of recesses and a plurality of projections.

Other aspects and advantages of the present invention will become apparent from the following description, taken in conjunction with the accompanying drawings, illustrating by way of example the principles of the invention.

The invention, together with objects and advantages thereof, may best be understood by reference to the following description of the presently preferred embodiments together with the accompanying drawings in which:

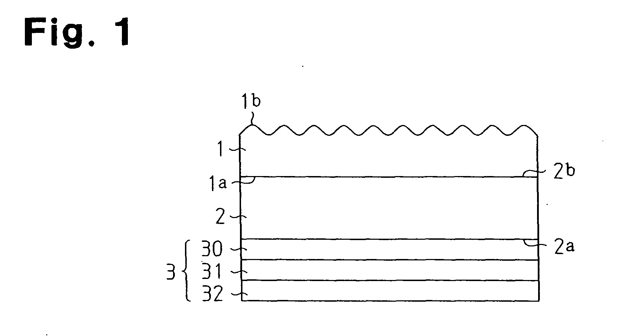

Fig. 1 is a cross-sectional view of an organic EL device according to a preferred embodiment of the present invention.

The term "transparent" used herein refers to the property of transmitting all of or some of the light rays emitted from an electroluminescence device. The transmittance of light in a transparent member is preferably 10% or greater, further preferably 50% or greater, and more preferably, 70% or greater. The transmittance may be different for each wavelength or may be the same for every wavelength.

An organic electroluminescence (EL) device according to a preferred embodiment of the present invention will now be described with reference to Fig. 1. The dimensions and magnification of the members shown in the drawings differ from the actual device.

Fig. 1 is a cross-sectional diagram of the organic EL device. As shown in Fig. 1, in the organic EL device, a transparent substrate 2 (having a first refractive index) includes a light incidence surface 2a and a light emission surface 2b. An organic EL element 3 is arranged on the light incidence surface (a first surface) 2a, and a high-refractive index transparent layer (having a second refractive index) 1 is arranged on the light emission surface (a second surface) 2b of the transparent substrate 2.

Light rays emitted out of the organic EL device pass through the transparent layer 1. The second refractive index of the transparent layer 1 is greater than the first refractive index of the transparent substrate 2.

The transparent substrate 2 supports the organic EL element 3. The light rays emitted out of the organic EL device pass through the transparent substrate 2. The transparent layer 1 and the transparent substrate 2 are transparent with respect to the light rays emitted from the EL device.

The organic EL element 3 includes an organic layer 31 containing an organic luminescent material, such as a fluorescent material or a phosphorescent material. The organic layer 31 is sandwiched between a transparent electrode 30, which is located on the side facing towards the transparent substrate 2, and a reflective electrode 32, which is located on the side facing away from the transparent substrate 2. The organic layer 31 generates light when voltage is applied between the two electrodes 30 and 32. The transparent electrode 30 is arranged between the organic layer 31 and the transparent substrate 2.

The transparent layer 1 will now be discussed. The transparent layer 1 has the properties described below.

The transparent layer 1 has a light entering surface (a third surface) 1a that contacts the light emission surface 2b of the transparent substrate 2. It is preferred that the light entering surface 1a be adhered in close contact with the transparent substrate 2. The transparent layer 1 also has a light exiting surface (a fourth surface) 1b with a plurality of recesses (valleys) recessed toward the light entering surface 1a and/or a plurality of projections (ridges) projecting away from the light entering surface 1a. It is preferred that the light exiting surface 1b be undulated or have a plurality of continuous microscopic waves. The refractive index of the transparent layer 1 is greater than that of the transparent substrate 2. The light rays that are to be emitted out of the EL device pass through the transparent layer 1.

As long as the properties described above are imparted to the transparent layer 1, the transparent layer 1 may be configured as follows.

It is required that the material forming the transparent layer 1 transmit the light rays emitted out of the organic EL device when processed in a laminated manner and that the material have a refractive index that is greater than that of the transparent substrate 2. Accordingly, the material of the transparent layer 1 differs in accordance with the type of EL device and the type of transparent substrate 2.

The material for forming the transparent layer 1 may be selected from, for example, polymethylmethacrylate (refractive index n = 1.49), ARTON (registered trademark, refractive index n = 1.51), ZEONOR (registered trademark, n = 1.52), glass (n = 1.53), polyvinylchloride (n = 1.54), polyethyleneterephthalate (n = 1.57), polycarbonate (n = 1.58), polystyrene (n = 1.59), and the like. The material forming the transparent substrate 2 of the organic EL device may also be used.

The process for forming the projections and recesses will now be discussed.

The light exiting surface 1b may have only the plurality of recesses recessed toward the light receiving surface 1a. Conversely, the light exiting surface 1b may have only the plurality of projections projecting away from the light receiving surface 1a. Alternatively, the light exiting surface 1b may have the plurality of recesses and the plurality of projections.

A known technique for forming microscopic projections and recesses may be employed. Examples for forming the projections and recesses are:
sandblasting the light exiting surface 1b of the transparent layer 1;
charging a material (liquid) for forming the transparent layer 1 into a mold, which is shaped in correspondence with the projections and recesses, to mold the transparent layer 1 with the light exiting surface 1b having the projections and recesses;
dry etching or wet etching the transparent layer 1 with a mask to partially remove the light exiting surface 1b; or
grounding the light exiting surface 1b.

The projections and recesses are sized to diffuse the emitted light rays. Further, the projections and recesses normally have a size of several micrometers (i.e., one to ten micrometers).

The pitch of the recesses and the pitch of the projections are determined in accordance with the properties required for the EL device. Normally, the pitch of the recesses and the projections is ten micrometers or less, and preferably five micrometers or less.

The process for forming the transparent layer 1 on the transparent substrate 2 will now be discussed.

The transparent layer 1 is formed on the transparent substrate 2 in accordance with a technique for laminating layers in an EL device such as an organic EL device. Examples for forming the transparent layer 1 are described below.

A material (liquid) for forming the transparent layer 1 may be applied to the light emission surface 2b of the transparent substrate 2 and dried. Alternatively, the material may be vapor deposited to form the transparent layer 1. The projections and recesses are formed in the light exiting surface 1b after formation of the transparent layer 1 on the transparent substrate 2.

The transparent layer 1 may be formed independently. In this case, the transparent layer 1 is thermally pressed on to the light emission surface 2b or adhered to the light emission surface 2b with an adhesive. And, the projections and recesses are formed on the light exiting surface 1b before the transparent layer 1 is attached to the transparent substrate 2. When adhering the transparent layer 1 to the transparent substrate 2, the refractive index of the hardened adhesive is greater than or equal to that of the transparent substrate 2 or less than or equal to the refractive index of the transparent layer 1. If the refractive index of the hardened adhesive is within this range, most of the light rays reaching the light emission surface 2b of the transparent substrate 2 enter the transparent layer 1.

The operation and advantages of the organic EL device according to the preferred embodiment of the present invention will now be discussed.

Since the transparent layer 1 has the properties described above, the organic EL device operates as described below.
(a) Most of the light rays entering the transparent substrate 2 from the organic EL element 3 enter the transparent layer 1. This is because the refractive index of the transparent layer 1 is greater than that of the transparent substrate 2 and most of the light rays reaching the light emission surface 2b of the transparent substrate 2 enter the transparent layer 1.
   Since the refractive index of the transparent layer 1 is greater than that of the transparent substrate 2, for the light rays entering the transparent layer 1 from the transparent substrate 2, the angle of incidence at the light emission surface 2b is less than the angle of emission at the light entering surface 1a. In other words, the light rays at the transparent layer 1 are more "focused" to a line normal to the light entering surface 1a than the light rays at the transparent substrate 2. That is, the light rays travel through the transparent layer 1 at an angle that is within a predetermined range from a line normal to the light entering surface 1a.
(b) The light rays emitted out of the organic EL element 3 pass through the transparent layer 1. Thus, the light rays entering from the light entering surface 1a of the transparent layer 1 reaches the light exiting surface 1b. This is because the transparent layer 1 is transparent with respect to the light to be emitted from the organic EL device.
(c) The light exiting surface 1b has projections and recesses. Thus, the "focused" light rays, of which angles relative to a line normal to the light entering surface 1a are within the above described predetermined range, are emitted out of the EL device.

As apparent from the operations described above, the organic EL device according to the preferred embodiment of the present invention significantly increases the light rays emitted in a direction generally normal to the light entering surface 1a (i.e., light incidence surface 2a) in comparison to the light rays emitted in other directions.

The other parts or layers will now be described.

The transparent substrate 2 is generally a plate-shaped member and functions to support the organic EL element 3. It is required that the transparent substrate 2 be transparent and have a refractive index that is lower than that of the transparent layer 1.

The organic EL element 3 is laminated on the light incidence surface 2a of the transparent substrate 2. Thus, it is preferred that the light incidence surface 2a be flat and smooth.

As long as it has the properties described above, a known substrate may be used as the transparent substrate 2. Normally, a glass substrate, a silicon substrate, a ceramic substrate such as a quartz substrate, or a plastic substrate may be used. Further, a substrate made of the above materials for forming the transparent layer 1 may be used. A composite substrate formed from a plurality of the same types of substrates or different types of substrates may be used.

The thickness of the transparent substrate 2 is not limited but is normally approximately one millimeter or less.

The organic EL element 3 includes the organic layer 31, which is arranged between the transparent electrode 30 and the reflective electrode 32. The organic layer 31 contains an organic luminescent material that generates light when voltage is applied between the two electrodes 30 and 32. The organic layer 31 is a layer having a known layer structure for a known organic EL element and is made of a known material through a known process.

As long as the organic layer 31 has the functions described below, it may be realized by either a single layer or a plurality of layers.

### Electron injection function:

Function for injecting electrons from electrode (cathode). Electron injection characteristic.

### Hole injection function:

Function for injecting holes from electrode (anode). Hole injection characteristic.

### Carrier transport function:

Function for transporting at least either one of electrons and holes. Carrier transport characteristic. The function for transporting electrons is referred to as the electron transport function (electron transport characteristic), and the function for transporting holes is referred to as the hole transport function (hole transport characteristic).

### Light emission function:

Function for recombining injected and transported electrons with holes to generate excitons (excited state) and generate light when returning to the ground state.

When the transparent electrode 30 is an anode, the organic layer 31 may, for example, include a plurality of layers laminated from the transparent electrode 30 in the order of hole injection transport layer, luminescence layer, and electron injection transport layer.

The hole injection transport layer functions to transport holes from the anode to the luminescence layer. The following are examples of the material for forming the hole injection transport layer:
Metal phthalocyanines, such as copper phthalocyanine and tetra(t-butyl)copper phthalocyanine, and non-metal phthalocyanines; small molecular weight materials or monomer materials, such as quinacridones, 1,1-bis(4-di-p-tolylaminophenyl)cyclohexane, N,N'-diphenyl-N,N'-bis-(3-methylphenyl)-1,1'-biphenyl-4,4'-diamine, N,N-di(1-naphthyl)-N,N'-dephenyl-1,1'-biphenyl-4,4'-diamine; polymer materials, such as polythiophene and polyaniline; polythiophene oligomer materials; and other hole transport materials.

The luminescence layer is a layer that recombines holes and electrons transported from the anode and the cathode to enter an excited state. As the luminescence layer returns from the excited state to the base state, the luminescence layer generates light. Fluorescent materials and phosphorescent materials may be used as the material of the luminescent material. Further, a dopant (a fluorescent material or a phosphorescent material) may be contained in the host material.

The following are examples of the material for forming the luminescence layer:
Small molecular weight materials or monomer materials, such as 9,10-diarylanthracene derivatives, pyrene derivatives, coronene derivatives, perylene derivatives, rubrene derivatives, 1,1,4,4-tetraphenylbutadiene, tris(8-quinolinolato)aluminum complex, tris(4-methyl-8-quinolinolato)aluminum complex, bis(8-quinolinolato)zinc complex, tris(4-methyl-5-cyano-8-quinolinolato)aluminum complexes, bis(2-methyl-5-trifluoromethyl-8-quinolinolato)[4-(4-cyanophenyl)phenolate] aluminum complexes, bis(2-methyl-5-cyano-8-quinolinolato)[4-(4-cyanophenyl)phenolate] aluminum complex, tris(8-quinolinolato) scandium complex, bis[8-(p-tosyl)aminominoquinoline]zinc complex and cadmium complex, 1,2,3,4-tetraphenylcyclopentadiene, pentaphenylcyclopentadiene, poly-2,5-diheptyloxy-p-phenylene vinylene, coumarin fluorescents, perylene fluorescents, pyrane fluorescents, anthrone fluorescents, polyphyrin fluorescents, quinacridone fluorescents, N,N'-dialkyl-substituted quinacridone fluorescents, naphthalimido fluorescents, N,N'-diaryl-substituted pyrrolo pyrrole fluorescents; polymer materials, such as polyfluorene, poly-p-phenylenevinylene, and polythiophene. When employing a host/guest configuration, an appropriate host and a guest (dopant) are selected from these materials.

The electron injection transport layer functions to transport electrons from the cathode (in the preferred embodiment, the reflective electrode 32) to the luminescence layer. The following are examples of the material for forming the electron transport layer:
2-(4-biphenylyl)-5-(4-t-butylphenyl)-1,3,4-oxadiazole, 2,5-bis(1-naphthyl)-1,3,4-oxadiazole and oxadiazole derivatives, bis(10-hydroxybenzo[h]quinolinolato)beryllium complex, and triazole compounds.

The organic layer 31 may include a layer that may be employed in a known organic electroluminescence layer, such as a buffer layer, a hole block layer, an electron injection layer, and a hole injection layer. These layers may also be formed through a known process using a known material. The electron injection transport layer may be formed by laminated layers that are divided in accordance with function into an electron injection layer functioning to inject electrons and an electron transport layer functioning to transport electrons. The material for forming each of these layers may be selected from known materials in accordance with the function of each layer and may be selected from the above materials for forming the electron injection transport layer.

The transparent electrode 30 and the reflective electrode 32 will now be discussed.

One of the electrodes 30 and 32 functions as an anode and the other one functions as a cathode. Any one of the electrodes 30 and 32 may function as the anode (or the cathode). The anode will first be described.

The anode is an electrode for injecting the holes into the organic layer 31. The material for forming the anode is not limited as long as the properties described above are imparted to the anode. The materials that may be used to form the anode normally include known materials, such as metals, alloys, electrically conductive compounds, and a mixture of these substances. It is preferred that the work function of the surface contacting the organic layer 31 be 4 eV or greater.

Examples of the material that may be used to form the anode include metal oxide or metal nitride, such as indium-tin-oxide (ITO), indium-zinc-oxide (IZO), tin oxide, zinc oxide, zinc aluminum oxide, and titanium nitride; metals, such as gold, platinum, silver, copper, aluminum, nickel, cobalt, lead, chromium, molybdenum, tungsten, tantalum, and niobium; an alloy of these metals or alloy of copper iodide; and conductive polymers, such as polyanyline, polythiophene, polypyrole, polyphenylene vinylene, poly(3-methylthiophene), and polyphenylene sulfide.

When the transparent electrode 30 is the anode, it is preferred that the transparent electrode 30 have a transmittance that is greater than the emitted light rays by 10%. For the emission of light rays in the visible band, it is preferred that the material of the transparent electrode 30 be ITO, which has high transmittance in the visible band.

The reflective electrode 32 is reflective when it is the anode. In this case, among the above materials, materials having properties that reflect light outward are selected. A metal, an alloy, or a metal compound is normally selected.

The anode may be formed of only one type of the above-described materials, or may also be formed by a mixture of a plurality of materials. Moreover, a multilayered structure constituted of a plurality of layers of the same composition or different compositions may also be formed.

The thickness of the anode is preferably 5 nm to 1 µm, more preferably 10 nm to 1 µm, further preferably 10 nm to 500 nm, yet more preferably 10 nm to 300 nm, and most preferably 10 nm to 200 nm.

The anode is formed using the above materials through known thin-film forming methods such as a sputtering process, an ion plating method, a vacuum vapor deposition method, a spin coating method, and an electron beam vapor deposition method. The sheet electric resistance of the anode is preferably several hundred Ω/□ (square) or less, and more preferably, 5 to 50 Ω/□ (square).

In order to clean the surface of the anode, UV ozone cleaning or plasma cleaning may also be carried out.

In order to inhibit short-circuits or defects of the organic EL device, surface roughness of the anode may be controlled through a method of miniaturizing the particle diameter or a method of polishing the formed film. It is preferred that a root-mean-square value of the surface roughness be 20 nm or less.

The cathode will now be described. The cathode, which is either one of the transparent electrode 30 and the reflective electrode 32, functions to inject electrons into the organic layer 31(the electron injection transport layer in the above structure). The cathode is formed from a material selected from a metal or an alloy, conductive compounds, the mixture thereof and the like having a work function of, for example, less than 4.5 eV, normally 4.0 eV or less, and preferably 3.7 eV or less.

As the above electrode substances, for example, lithium, sodium, magnesium, gold, silver, copper, aluminium, indium, calcium, tin, ruthenium, titanium, manganese, chromium, yttrium, aluminium-calcium alloys, aluminium-lithium alloys, aluminium-magnesium alloys, magnesium-silver alloys, magnesium-indium alloys, lithium-indium alloys, sodium-potassium alloys, sodium-potassium alloys, magnesium/copper mixtures, and aluminium/aluminium oxide mixtures can be used. Further, the anode materials may be used for the cathode.

If the reflective electrode 32 is the cathode, it is preferable to select a material that reflects the light to be emitted among the materials described above. Generally, metals, alloys, and metal compounds can be used for the material of the reflective electrode 32.

If the transparent electrode 30 is the cathode, the transmittance is normally set to be 10% greater than the emitted light rays. For example, an electrode formed by laminating a transparent conductive oxide on an extremely thin film of a magnesium-silver alloy is employed.

In the cathode, a buffer layer added with copper phthalocyanine and the like is arranged between the cathode and the organic layer 31 to prevent the luminescence layer from being damaged by the plasma when sputtering conductive oxide.

The cathode may be formed by only one of the above materials or by a plurality of the same. For example, if 5% to 10% of silver or copper is added to magnesium, it is possible to prevent the cathode from being oxidized and enhance adhesion between the cathode and the organic layer 31.

Further, the cathode may have a multi-layered structure composed of a multiple layers having the same composition or different compositions.

For example, the cathode may be configured as follows.

To prevent oxidization of the cathode, a protective layer formed of a corrosion-resistant metal is provided at a portion of the cathode that is out of contact with the organic layer.

Preferably, the protective layer is formed of silver or aluminum.

To reduce the work function of the cathode, an oxide, a fluoride, or a metal compound, which has a small work function, is inserted into an interface portion between the cathode and the organic layer.

For example, the cathode that is used may be formed of aluminum, with lithium fluoride or lithium oxide inserted in the interface portion.

The cathode may be formed by any of the known thin layer-forming methods, such as the vacuum vapor deposition method, the sputtering method, the ionization vapor deposition method, the ion plating method, and the electron beam vapor deposition method.

It is preferred that the sheet electric resistance of the cathode be several hundred Ω/□ or less.

In addition to the above materials and structures, known layer structures and materials used for a known organic EL element may be employed for the organic EL element 3. The preferable layer and material that may be employed will now be described.

An insulation layer may be arranged around the organic layer 31 to prevent short-circuiting between the transparent electrode 30 and the reflective electrode 32.

A material for forming a known organic EL element may be employed as the material for forming the insulation layer. A known process for forming the insulation layer may be employed. For example, sputtering, electron beam vapor deposition, or chemical vapor deposition (CVD) may be employed.

An auxiliary electrode may of course be arranged. The auxiliary electrode is arranged so as to electrically connect with the anode and/or cathode, and is made of a material having a volume resistivity lower than the connecting electrode. When the auxiliary electrode is formed with such material, the volume resistivity of the entire electrode including the auxiliary electrode is lowered and the maximum difference of the magnitude of the current flowing through each point constituting the organic layer 31 becomes smaller than when the auxiliary electrode is not included.

The materials for forming the auxiliary electrode include tungsten (W), aluminum (A1), copper (Cu), silver (Ag), molybdenum (Mo), tantalum (Ta), gold (Au), chromium (Cr), titanium (Ti), neodymium (Nd), and the alloys thereof.

Examples of such alloys include alloys of Mo-W, Ta-W, Ta-Mo, Al-Ta, Al-Ti, Al-Nd, and Al-Zr. Further, the compounds of metal and silicon, TiSi₂, ZrSi₂, HfSi₂, VSi₂, NbSi₂, TaSi₂, CrSi₂, WSi₂, CoSi₂, NiSi₂, PtSi, Pd₂Si etc. are also preferable as the materials for configuring the auxiliary wiring layer. The configuration in which the above metal or silicon compounds are respectively laminated may also be used.

The auxiliary electrode may be a single-layer film made of the above material, but may preferably be a multilayered film of two or more kinds to enhance the stability of the film. The multilayered film may be formed using the above metal or the alloys thereof. For example, the combination may be Ta layer, Cu layer and Ta layer, or Ta layer, A1 layer and Ta layer in the case of three layers; and A1 layer and Ta layer, Cr layer and Au layer, Cr layer and A1 layer, or A1 layer and Mo layer in the case of two layers.

The stability of the film is the property of maintaining low volume resistivity while being not easily corroded by the liquid used in the process during etching. If the auxiliary electrode is composed of Cu or Ag, the volume resistivity itself of the auxiliary electrode is low but is easily corroded.

The stability of the auxiliary electrode is enhanced by laminating a film of a metal having excellent corrosion resistivity such as Ta, Cr, Mo and the like on both or one of the upper part or the lower part of the metal film composed of Cu or Ag.

The thickness of the auxiliary electrode is preferably a value generally within the range of 100 nm to a few 10 µm, and more preferably a value within a range of 200 nm to 5 µm.

This is because if the thickness is less than 100 nm, the value of resistance becomes greater and is not preferable as the auxiliary electrode, and if the thickness is greater than 10 µm, the film can not be easily planarized and may cause defects in the organic EL element 3.

The width of the auxiliary electrode is preferably a value within a range of for example, 2 µm to 1000 µm, and more preferably a value within a range of 5 µm to 300 µm.

This is because if the width is less than 2 µm, the resistance of the auxiliary electrode becomes greater, and if the width is greater than 1000 µm, the light is inhibited from exiting outwards.

A passivation film (protection film) or a seal, such as an encapsulation can, may be arranged on the organic EL element 3 to protect the organic layer 31 from ambient air. The passivation film is a protection layer located on the opposite side of the transparent substrate 2 to prevent the organic EL element 3 from coming into contact with oxygen or moisture. Examples of the material used for the passivation film layer include organic polymeric materials, inorganic materials, and photo-setting resin. The material used for the passivation film may be used alone or as a combination of a plurality of materials. The passivation film may also have either a mono-layer structure or a multilayered structure. Further, it is only required that the passivation film be thick enough to shield out moisture and gases.

Examples of the organic polymeric material include fluorine based resin of copolymers such as chlorotrifluoroethylene polymer, dichlorodifluoroethylene polymer, and copolymer of chlorotrifluoroethylene and dichlorodifluoroethylene; acrylic resin such as polymethyl methacrylate and polyacrylate; epoxy resin; silicone resin; epoxy silicone resin; polystyrene resin; polyester resin; polycarbonate resin; polyamide resin; polyimide resin; polyamideimide resin; polyparaxylene resin; polyethylene resin; and polyphenylene oxide resin.

Examples of the inorganic material include polysilazane, diamond thin film, amorphous silica, electrically insulating glass, metal oxide, metal nitride, metal carbide, and metal sulfide.

The seal is configured by a seal member, such as a seal plate or a seal container, to shield out moisture and oxygen. The seal member may be disposed only on the rear-surface side (electrode side) of the organic EL device, or the whole organic EL device may be coated with the seal member. When the organic layer is sealed and shielded from ambient air, the shape, size, and thickness of the seal member is not especially limited. Examples of the material for forming the seal member include glass; stainless steel, metal (e.g., aluminum); plastic (e.g., polychlorotrifluoroethylene, polyester, polycarbonate); and ceramic.

When the seal member is arranged in the organic EL element 3, a sealant or an adhesive may also be used. When the whole organic EL element 3 is coated with the seal member, instead of using the sealant, seal members may be thermally bonded to one another. Examples of the sealant include an ultraviolet setting resin, thermal setting resin, and two-liquid type setting resin.

Furthermore, a moisture absorbent may be inserted between the passivation film or seal and the organic EL element 3. The moisture absorbent is not especially limited. Examples of the moisture absorbent include barium oxide, sodium oxide, potassium oxide, calcium oxide, sodium sulfate, calcium sulfate, magnesium sulfate, phosphorus pentoxide, calcium chloride, magnesium chloride, copper chloride, cesium fluoride, niobium fluoride, calcium bromide, vanadium bromide, molecular sieve, zeolite, and magnesium oxide.

An inert gas may be sealed in the passivation film or the seal. The inert gas is a gas that does not react to the organic EL element 3. Further, the inert gas may be a rare gas, such as helium or argon, or nitrogen gas.

A layer for enhancing the adhesion between the layers or enhancing electron or hole injection properties may also be provided.

For example, a cathode interface layer (mixed electrode) obtained by the co-vapor deposition of the material forming the cathode and the material forming the electron injection transport layer may also be arranged between the layers. Accordingly, an electron injection energy barrier existing between the luminescence layer and the cathode is alleviated. The adhesion between the cathode and the electron injection transport layer is also enhanced.

The material for forming the cathode interface layer is not especially limited and known materials may be used as long as the material imparts the above-described properties to the cathode interface layer. Examples of such material include fluoride, oxide, chloride, and sulfide of alkaline metal and alkaline earth metal, such as lithium fluoride, lithium oxide, magnesium fluoride, calcium fluoride, strontium fluoride, and barium fluoride. The cathode interface layer may be formed of either a single material or a plurality of materials. The thickness of the cathode interface layer is preferably 0.1 nm to 10 nm, and more preferably 0.3 nm to 3 nm.

As to the thickness of the cathode interface layer, the layer may be formed to be uniform, non-uniform, or insular, and may be formed by known thin-film forming methods, such as vacuum vapor deposition.

In at least one of the spaces between layers, a layer (block layer) for inhibiting movement of the holes, electrons, or excitons may also be used. For example, a hole block layer may be arranged adjacent to the cathode side of the luminescence layer to inhibit the passage of the holes through the luminescence layer and efficiently recombine the electrons in the light emitting layer. Examples of the material for forming the hole block layer include known materials such as triazole derivatives, oxadiazole derivatives, BAlq, and phenanthroline derivatives. However, the material of the hole block layer is not limited to these materials.

A layer (buffer layer) for alleviating the injection barrier of the holes and electrons may be arranged in at least one of the spaces between layers. For example, the buffer layer may be inserted between the anode and hole injection transport layer or between the organic layers laminated adjacent to the anode to alleviate the injection barrier with respect to the hole injection. As the material for forming the buffer layer, known materials, such as copper phthalocyanine are used. However, the material of buffer layer is not limited to these materials.

The hole injection transport layer or the electron injection transport layer may be doped with organic luminescence materials (dopants) such as a fluorescent material or a phosphorescent material to emit light from these layers.

When the cathode is formed of metal, such as aluminum, the layer adjacent to the cathode may be doped with alkaline metal or an alkaline metal compound in order to alleviate the energy barrier between the cathode and the organic layer. Since the organic layer is reduced by the added metal or metal compound to generate anions, the electron injection properties are enhanced, and the applied voltage drops. Examples of the alkaline metal compound include oxide, fluoride, and lithium chelate.

It should be apparent to those skilled in the art that the present invention may be embodied in many other specific forms without departing from the spirit or scope of the invention. Therefore, the present examples and embodiments are to be considered as illustrative and not restrictive, and the invention is not to be limited to the details given herein, but may be modified within the scope and equivalence of the appended claims.

A bottom emission type electroluminescence device for emitting an increased amount of light rays in a direction that is within a predetermined angle relative to a light incidence surface of a transparent substrate. The transparent substrate (2) is sandwiched between an electroluminescence element (3) and a transparent layer (1). The refractive index of the transparent layer is greater than that of the transparent substrate. A plurality of projections and recesses are formed on the upper surface (1b) of the transparent layer.

## Claims

1. An electroluminescence device including:
a transparent substrate having a first refractive index and including a first surface and a second surface;
an electroluminescence element arranged on the first surface of the transparent substrate; and
a transparent layer laminated on the second surface of the transparent substrate, wherein the electroluminescence element generates light rays that pass through the transparent substrate to be emitted from the fourth surface, the device being **characterized in that**
the transparent layer has a second refractive index that is greater than the first refractive index of the transparent substrate and including a third surface contacting the second surface of the transparent substrate and a fourth surface opposite to the third surface; and
the fourth surface of the transparent layer has at least either one of a plurality of recesses and a plurality of projections.

2. The electroluminescence device according to claim 1, wherein the recesses are arranged adjacent to one another at a pitch of ten micrometers or less.

3. The electroluminescence device according to claim 1, wherein the recesses each have a depth of ten micrometers or less.

4. The electroluminescence device according to claim 1, wherein the projections are arranged adjacent to one another at a pitch of ten micrometers or less.

5. The electroluminescence device according to claim 1, wherein the projections each have a height of ten micrometers or less.

6. The electroluminescence device according to claim 1, wherein the fourth surface is undulated.

7. The electroluminescence device according to claim 1, wherein either one of the plurality of recesses and the plurality of projections form smooth and continuous microscopic waves.

8. The electroluminescence device according to claim 1, wherein the electroluminescence element is an organic electroluminescence element.

9. A method for manufacturing an electroluminescence device, the method **characterized by**:
preparing a transparent substrate having a first refractive index and including a first surface and a second surface;
arranging an electroluminescence element on the first surface of the transparent substrate; and
laminating a transparent layer on the second surface of the transparent substrate, the transparent layer having a second refractive index that is greater than the first refractive index of the transparent substrate and including a third surface contacting the second surface of the transparent substrate and a fourth surface opposite to the third surface, wherein the fourth surface of the transparent layer has at least either one of a plurality of recesses and a plurality of projections.

10. The method according to claim 9, wherein said laminating a transparent layer includes:
providing the transparent layer; and
adhering the transparent layer to the second surface of the transparent substrate.

11. The method according to claim 10, wherein said providing the transparent layer includes:
providing a mold, which is shaped in correspondence with said at least either one of a plurality of recesses and a plurality of projections; and
charging a liquid material for forming the transparent layer into the mold to mold the transparent layer with the light exiting surface having said at least either one of a plurality of recesses and a plurality of projections.

12. The method according to claim 9, wherein said laminating a transparent layer includes:
preparing a material for forming the transparent layer;
applying the material on the entire second surface of the transparent substrate;
drying the material; and
forming at least either one of a plurality of recesses and a plurality of projections on the dried material.
